# EUROPEAN PATENT APPLICATION

(11) **EP 1 722 018 A1**
(43) Date of publication of application: **15.11.2006**
(21) Application number: 05709884.0
(22) Date of filing: 08.02.2005
(51) Int. Cl.: D03D 15/12, D03D 11/00, B29B 11/16, B29K 105/10

(54) **DOUBLE GLASS CLOTH, AND PREPREG AND SUBSTRATE FOR PRINTED WIRING BOARD USING THE GLASS CLOTH**

(30) Priority: 09.02.2004 JP 2004032162
(71) Applicant: Asahi-Schwebel Co., Ltd., Osaka-shi, Osaka 530-8205 (JP)
(72) Inventor: GONDOH, Yoshinori, 5203041 (JP); SOMEYA, Makoto, 5203102 (JP); KIMURA, Yasuyuki, 5202152 (JP)
(74) Representative: Price, Paul Anthony King
(86) International application number: PCT/JP2005/001832
(87) International publication number: WO 2005/075724

(57) **Abstract**

A double glass cloth for a printed wiring board, **characterized in that** it is a glass cloth composed of warps and wefts and has a double structure comprising a face side structure and a back side structure, wherein said face side structure and said back side structure are bound with a woven structure into one piece.

## Description

### Technical Field

The present invention relates to a glass cloth used for a printed wiring board.

### Background Art

A double sided printed wiring board is normally manufactured following the steps below. First, in a prepreg manufacturing step, a base material such as a glass cloth is impregnated with varnish made of thermo-setting resin such as epoxy resin and a solvent, heated and dried to thereby create a prepreg. Second, in a stacking step, a single prepreg or a plurality of prepregs are stacked, copper foil is pasted to both sides of the laminated sheet obtained, and heated, pressed and cured to thereby create a coppered laminated sheet. Third, in a circuit pattern formation step, a circuit pattern made of copper foil is created on both sides of the coppered laminated sheet through photolithography and etching or plating. Finally, in a through hole processing step, through holes are formed using a drill or laser and electrical connections of both sides are secured through a publicly known step such as electroless copper plating. It is generally known that due to the heat and pressure in the above described stacking step or in the circuit pattern formation step, part of the copper foil is etched out and the dimension of the coppered laminated sheet is thereby changed.
Furthermore, it is possible to manufacture a multilayer printed wiring board through a sequential molding method using the above described double sided printed wiring board as a core substrate, by overlaying the above described single prepreg or plurality of prepregs on the surface layer, pasting the copper foil on both sides of the laminated sheet obtained, heating and pressing, and hardening and adhering the laminated sheet.

In order to realize higher-performance, smaller and lighter digital devices in recent years, printed wiring boards used for such devices are also required to be smaller, slimmer and denser. A possible technique therefor may be to increase the number of layers of a build-up multilayer printed wiring board using the above described sequential molding method, but a batch molding method is often used in recent years whereby double sided printed wiring boards are stacked together with an interconnecting body interposed in between, heated and pressed, and cured and adhered all at once. For the prepreg which becomes an interconnecting body (hereinafter referred to as "interconnecting prepreg" when the prepreg used to manufacture a core substrate and the prepreg which becomes the interconnecting body need to be distinguished), it is possible to form a through hole (interstitial via hole or inner via hole, abbreviated as an "IVH") right below a part land or between arbitrary layers by filling the IVH with a conductor such as conductive paste. For this reason, there are proposals of a multilayer printed wiring board having a total layer IVH structure capable of realizing a size reduction of the substrate and high density mounting.

These methods of manufacturing a multilayer printed wiring board try to further achieve the aforementioned size reduction, thickness reduction and higher density by reducing the thickness of a core substrate and interconnecting prepreg which make up each layer. However, as the thickness of a material making up each layer decreases, the ease of handling of the substrate during transportation or the like deteriorates, and therefore it is necessary to improve rigidity of the interconnecting prepreg and core substrate used.
Furthermore, in realizing a high-density printed wiring board, further dimensional stability of the substrate and reduction of variation in particular are required to improve yield as with the substrate and prepreg necessary for thickness reduction. With the increase of via connections between layers due to a multilayer structure, it is also necessary to reduce the coefficient of thermal expansion in the thickness direction (Z direction) to improve connection reliability in the thickness direction.

There is a proposal to use a three-dimensional-structured woven glass (hereinafter referred to as "three-dimensional glass") as a base material capable of reducing the coefficient of thermal expansion in the thickness direction for a printed wiring board (see Patent Document 1 and Patent Document 2). Patent Document 1 defines the above described three-dimensional structured woven fabric as a cloth made up of fiber in the longitudinal direction, fiber in the lateral direction and fiber in the thickness direction, and more specifically describes a structure in which layers of fibers arrayed in parallel in the longitudinal direction and layers of fibers arrayed in parallel in the lateral direction are alternately stacked one atop another and fibers in the thickness direction are passed so as to weave gaps in the vertical direction which exist between the fibers in the longitudinal direction and fibers in the lateral direction. Patent Document 2 does not describe any specific three-dimensional glass structure. According to the description of Patent Document 1, the coefficient of thermal expansion in the Z direction of the printed wiring board using the three-dimensional glass is estimated to be approximately 1/3 of a conventional example using plain weave glass. Though not described in Patent Document 1, the rigidity of a printed wiring board using the three-dimensional glass is expected to be higher than that of the conventional example.
However, weaving the above described three-dimensional glass requires a special loom applicable to three directions; fibers in the longitudinal direction (warps), fibers in the lateral direction (wefts) and fibers in the thickness direction and there is a large problem that the three-dimensional glass cannot be woven using a normal loom only applicable to two directions of warps and wefts.
Furthermore, the three-dimensional glass also has a problem that the distribution of the amount of glass in the thickness direction drastically varies from one place to another. When through holes or IVHs are formed in a printed wiring board, differences in the distribution of the amount of glass in the thickness direction cause variations in the shape of holes. For a two-dimensional-structured woven fabric such as a plain weave glass cloth, fiber-opening process is known to have an effect in reducing the above described variations. However, in the case of the above described three-dimensional glass, since fibers in the thickness direction are arrayed and constrained on the same line in the vertical direction, even if fiber-opening process is applied, it is difficult to eliminate the variations. Because of these problems, the above described three-dimensional glass is not used as a base material for the printed wiring board.

Thus, in the case of a core substrate, it is a general practice to use a technique of creating the substrate by stacking a plurality of prepregs using an available thinnest glass cloth, applying hot/pressure molding thereto to achieve high rigidity. For example, when a core substrate of 100 µm in thickness is created, if the glass content is the same, a core substrate made up of two prepregs of 50 µm in thickness has higher rigidity than a core substrate made up of a single prepreg of 100 µm in thickness. Likewise, a core substrate created of three prepregs of 33 µm in thickness is more preferable.
However, a prepreg using an extremely thin glass cloth has poor yield of operability in the manufacturing step and causes a cost increase with an increase in the number of glass cloths used, which is not desirable. Furthermore, while the core substrate consisting of the above described plurality of stacked prepregs improves rigidity, it has no effect on the reduction of the coefficient of thermal expansion in the Z direction.
Furthermore, in the case of the interconnecting prepreg, a method of manufacturing a prepreg by continuously impregnating a roll of glass cloth with varnish is currently in the mainstream. This involves a problem that it is difficult to stack a plurality of intermediate prepregs. Thus, as a technique capable of increasing rigidity without stacking prepregs, a manufacturing method of impregnating a plurality of glass cloths overlaid one another with varnish to obtain a single prepreg is proposed (see Patent Document 3).
However, according to this technique, when a plurality of extremely thin glass cloths each having a thickness of 50 µm or less are used, loose and wrinkles or the like are produced in the glass cloths and it is difficult to obtain uniform prepregs. Even if the line tension during manufacturing of prepregs is drastically increased and loose and wrinkles can be avoided, there is still a problem that large residual stress impairs stability in dimensional variations in the stacking step. Furthermore, a core substrate made up of a single prepreg converted from a plurality of glass cloths has improved rigidity but has no effect on a reduction of the coefficient of thermal expansion in the Z direction.

On the other hand, there is a proposal of a printed wiring board using a glass cloth of weft backed satin weave and warp backed satin weave, which is a one-sided combination structure intended to reduce warpage and torsion of the printed wiring board (see Patent Document 4). The "one-sided combination structure" is a weave using two or more types of yarn for any one of warp and weft, and the weft backed weave is a combination structure created using one type of warp and two types of weft. In such a woven structure, the face weave is woven with warps and face side wefts and the back weave is woven with warps and back side wefts. The warp backed weave is similar to the weft backed weave with only the longitudinal/lateral relationship is inverted.
The glass cloth described in Patent Document 4 provides satin weave with fewer crosses between warps and wefts to reduce crimp of woven fabric and also provides a one-sided combination structure to cancel differences between the face and back sides of satin weave. With the use of the woven fabric of one-sided combination structure, it is possible to obtain a glass cloth having a thickness of approximately 1.5 times that of a normal single structure with no difference between the face and back sides, but this does not contribute to improvement of rigidity of prepregs. Moreover, satin weave has a weak binding force between yarns, is liable to bowed filling and not suitable for a thin glass cloth.

Patent Document 1: JP-B-7-36465
Patent Document 2: JP-A-7-202362
Patent Document 3: JP-A-9-151027
Patent Document 4: JP-A-2001-55642

### Disclosure of the Invention

### Problem to Be Solved by the Invention

It is an object of the present invention to provide a glass cloth which can be woven without using any special loom, capable of improving rigidity necessary for reducing the thickness of a core substrate and prepreg used for a double sided printed wiring board, improving productivity and reducing variations in the amount of dimensional change and coefficient of thermal expansion in the thickness direction, a prepreg using the glass cloth and a substrate for a printed wiring board using the prepreg.

### Means for Solving the Problem

The present inventors have made every effort to solve the above described problems focusing attention to the woven structure of a glass cloth made up of warps and wefts and consequently have come to complete the present invention by discovering that using a double glass cloth having a double structure with two glass cloths stacked one atop the other and the two bound into a woven structure as a substrate makes it possible to stably obtain a prepreg having rigidity equivalent to that of two prepregs stacked and molded using one glass cloth and also reduce variations in dimensional stability and the coefficient of thermal expansion in the thickness direction.

That is, the first aspect of the present invention is a double glass cloth for a printed wiring board, characterized in that it is composed of warps and wefts and has a double structure comprising a face side structure and a back side structure, wherein said face side structure and said back side structure are bound with a woven structure into one piece.
The double glass cloth is preferably made up of the face side structure that consists of face side warps which only weave the face side structure, face side wefts which only weave the face side structure and common yarns which weave both the face side structure and the back side structure, and the back side structure that consists of back side warps which only weave the back side structure, back side wefts which only weave the back side structure and the common yarns which weave both the face side structure and the back side structure. Furthermore, the double glass cloth is more preferably made up of the face side structure and back side structure each having a plain weave. Moreover, the double glass cloth is most preferably made up of the face side structure and back side structure bound together at a rate of at least one location per unit structure.
The second aspect of the present invention is a prepreg for a printed wiring board comprising the glass cloth in the first aspect of the invention and a semi-cured matrix resin.
The third aspect of the present invention is a substrate for a printed wiring board formed by heating, pressing and curing the prepreg in the second aspect of the invention.
The fourth aspect of the present invention is a method of manufacturing a printed wiring board comprising a step of stacking a single prepreg or a plurality of prepregs in the second aspect of the invention, pasting copper foil on both sides of the laminated sheet obtained, heating, pressing and curing the laminated sheet to thereby create a coppered laminated sheet, a step of creating a circuit pattern made of copper foil on both sides of the coppered laminated sheet and a step of forming through holes and securing electrical connections between the circuit patterns on both sides.

### Advantages of the Invention

The printed wiring board molded with the prepregs using the glass cloth of the present invention provides excellent productivity and rigidity and has the effect of being able to reduce variations in the amount of dimensional change and reduce a coefficient of thermal expansion in the thickness direction.
Brief Description of the Drawings
Fig. 1 shows three side views showing the woven structure of a glass cloth according to Examples 1 to 3;
Fig. 2 is a weave diagram of the glass cloth according to Examples 1 to 3;
Fig. 3 is a weave diagram of a glass cloth according to Example 4;
Fig. 4 is a weave diagram of a glass cloth according to Example 5;
Fig. 5 is a weave diagram of a glass cloth according to Example 6; and
Fig. 6 is a weave diagram of a glass cloth according to Example 7.

### Best Mode for Carrying Out the Invention

The present invention will be explained more specifically below.
(1) Features of glass cloth
   The glass cloth of the present invention is a double glass cloth having a double structure with two stacked glass cloths consisting of warps and wefts and with the two cloths bound with a woven structure into one piece. The "cloth having a double structure" is made up of two single structures stacked in the vertical direction and simultaneously woven, and a face side structure which becomes a face side is made up of face side warps and face side wefts, while a back side structure which becomes a back side is made up of back side warps and back side wefts. Such a woven structure has the face side structure and back side structure bound together, and has therefore the effect of being able to reduce a coefficient of thermal expansion in the thickness direction. Note that the cloth having a double structure is different from the cloth having a one-sided combination structure described in aforementioned Patent Document 4 in that at least two types of warps and two types of wefts are used.
   It is preferable that the above described warps on the face side and back side be of the same type of yarn and wefts on the face side and back side be of the same type of yarn and it is more preferable that warps and wefts be of the same type of yarn, but all these may also be of different types of yarn.
   A preferred example of the cloth in a double structure is a double glass cloth in which the face side structure consist of face side warps which only weave the face side structure, face side wefts which only weave the face side structure and common yarns which weave both the face side structure and the back side structure, while the back side structure consists of back side warps which only weave the back side structure, back side wefts which only weave the back side structure and the common yarns which weave both the face side structure and the back side structure. Here, the common yarn constitutes a woven structure which binds the face side structure and the back side structure or part thereof and can be composed of only warps or only wefts or both warps and wefts.
   Adopting such a woven structure considerably reduces the number of overlapping of crossover points of warps and wefts at which the face side structure and back side structure overlay with each other and has an effect of excellent boring workability. Especially when two extremely thin plain weave glass cloths are simply overlaid with each other, two types of areas are produced irregularly, areas where the glass cloths overlay with each other in the vertical direction and areas where the glass cloths overlay with each other by being alternately dislocated. On the other hand, in the double glass cloth according to the present invention, neighboring yarns are basically divided into upper and lower parts, and therefore when viewed from the surface, yarns are uniformly arranged, providing excellent uniformity in the plane direction in the drilling and laser work or the like.
   Furthermore, adopting the double glass cloth of the present invention as two continuous layers of glass cloths having a multilayer structure of triple or higher level of weaving is also preferable from the standpoint of improvement of rigidity.

Both the face side structure and back side structure of the double glass cloth of the present invention preferably have a plain weave as a basis with a woven structure for binding both structures added thereto. This is because the plain weave has an excellent force of binding of warps and wefts compared to a twill weave and satin weave having low binding forces and it is possible to maintain a regular woven structure of also a glass cloth made up of thin yarns liable to bowed filling of cloth and suppress variations in dimensional stability.
Furthermore, with regard to a technique of binding (connection), it is preferable to continuously or partially bind over the entire width of the cloth at one or more points and more preferable to uniformly arrange binding points over the entire surface of the cloth and make them sink and float in the vertical direction as with the surrounding structure as much as possible. As the cloth having a double structure, a cloth of hollow weave is well known, but the hollow weave is bound with a woven structure only at an end and cannot be said to be a mode preferable for the purpose of a double glass cloth for a printed wiring board of the present invention.
That is, when both structures are bound at one or more points in accordance with cutting widths of prepregs, it is possible to suppress a slump in the face side structure and back side structure and stably manufacture prepregs. Furthermore, the "case where binding points are uniformly arranged" means that the face side structure and back side structure are bound at a rate of at least one location per unit structure. This makes it possible to increase the cloth binding force, suppress the bowed filling and further reduce variations in dimensional changes. In addition, the reinforcement effect in the thickness direction is also increased, and therefore it is also possible to reduce the coefficient of thermal expansion in the thickness direction which is advantageous in improvement of reliability of inter-layer connections of a multilayer printed wiring board.

The total thickness of the two layers of the double glass cloth according to the present invention is preferably 10 µm or more and 400 µm or less, more preferably 10 µm or more and 200 µm or less, and especially when the total thickness is 10 µm or more and 100 µm or less, it is possible to effectively improve the workability and quality of an extremely thin glass cloth when the thickness per layer is, for example, 50 µm or less, which is preferable. It is extremely difficult to manufacture a double glass cloth having a thickness of less than 10 µm and when the thickness is greater than 300 µm, the glass yarn used is thick and the distance between neighboring yarns is narrow, and therefore it is difficult to arrange warps and/or wefts alternately in the vertical direction and yarns overlay with one another, making it difficult to manufacture a glass cloth.
In order to reduce the thickness of the glass cloth, a constituent single fiber of glass yarn of a small diameter is more effective, but when the single fiber is too thin, there is a problem with its strength. For this reason, the glass yarn preferably has a single fiber having a nominal diameter of 3 (diameter of approximately 3.0 µm) or more specified by JIS R3413 and nominal diameter of 7 (diameter of approximately 7.0 µm) or less and more preferably a nominal diameter of 3 (diameter of approximately 3.0 µm) or more and nominal diameter of 6 (diameter of approximately 6.0 µm) or less.
As a glass yarn for composition, it is preferable to use a glass yarn subjected to twisting with a twist number per inch of 0 to 1.0 and more preferable to use a low twisted yarn with a twist number of 0 to 0.2 (hereinafter a low twisted yarn with a twist number of 0 will be referred to as "non-twisted yarn"). Or it is also possible to use a glass cloth whose twist number per inch is reduced to 0.2 or less by performing weaving while untwisting normal twisted yarns. Reducing the twist number causes the section of a yarn to approximate to a flat shape, and therefore it is possible to reduce in-plane gaps of a double glass cloth, increase uniformity in the amount of glass distribution in the plane direction and simultaneously suppress the amount of warpage or torsion of the substrate due to a force of restoring twisting of the glass yarn.

(2) Fiber-opening processing of glass cloth
   In order to obtain a glass cloth used for a prepreg of the present invention, it is preferable to perform fiber-opening to spread out single fibers in a bundle of glass yarn. Through the fiber-opening processing, it is possible to reduce in-plane gaps of a double glass cloth. Furthermore, it goes without saying that the fiber-opening processing makes it possible to improve an impregnation characteristic of resin varnish, increase uniformity between glass and matrix resin and improve thermal resistance or the like.
   When each layer of the glass cloth is observed from the surface, the average length of the smaller side of the gap enclosed by warps and wefts (hereinafter referred to as "gap length") is preferably between 0 µm and 50 µm and more preferably between 0 µm and 30 µm. When the gap length is between 0 µm and 50 µm, it is possible to improve quality of holes worked using a drill or laser.
   Examples of the fiber-opening processing include fiber-opening by a water flow pressure, fiber-opening by vibration of high frequency using a liquid as a medium, working with a pressure of a liquid having a contact pressure and working under a pressure using a roll or the like. Applying the fiber-opening processing causes single fibers in a bundle of yarn to be spread out. Among these fiber-opening processing methods, opening by a water flow pressure or fiber-opening by vibration of high frequency using a liquid as a medium is preferable in terms of uniformity. Furthermore, to enhance the effect of the fiber-opening processing, it is preferable to perform fiber-opening processing with tension applied to the glass cloth reduced for transportation.
   Furthermore, in a glass cloth with an organic compound displaying a lubricant characteristic stuck to the glass yarn or a binder used to weave a normal glass cloth or glass cloth with a textile size or the like stuck thereto (hereinafter referred to as "greige fabric"), it is possible to further increase the effect of making single fibers in a bundle of yarn spread out by combining fiber-opening processing and twisting reduction.
   Furthermore, it is possible to further widen gaps between bound glass single fibers by performing fiber-opening processing, then applying surface treatment using a silane coupling agent, which will be described later, and further performing fiber-opening processing.
   In the case where fiber-opening processing is applied to the double glass cloth of the present invention, it is more preferable to prevent the face side and back side from being generated in each layer of the double glass cloth using a method of applying fiber-opening processing from both sides, for example.
   When a yarn bundle of the glass cloth is widened, it goes without saying that the laser workability (uniformity of hole diameter distribution, working speed or the like) also improves.

(3) Glass composition and surface treatment
   For a glass cloth of a laminated sheet used for a printed wiring board or the like, glass called "E glass (non-alkali glass)" is normally used, but it is also possible to use low dielectric constant glass such as D glass, high-strength glass such as S glass and high dielectric constant glass such as H glass or the like.
   Likewise, for a glass cloth of a laminated sheet used for a printed wiring board or the like, surface treatment using a processing liquid including a silane coupling agent is normally applied, but it is possible to use a silane coupling agent commonly used as the silane coupling agent and add acid, dye, pigment, surface activating agent or the like as required.
(4) Manufacturing and features of prepreg
   The prepreg of the present invention can be manufactured following an established method. For example, the glass cloth of the present invention is impregnated with varnish which is obtained by diluting matrix resin such as epoxy resin with an organic solvent, then an organic solvent is volatilized in a drying furnace, thermo-setting resin is cured to a B stage condition (semi-cured condition) and a resin-impregnated prepreg can be thereby created. In this case, it is preferable to minimize tension which is applied to the glass cloth because in this way it is possible to obtain a prepreg with excellent dimensional stability.
   In addition to the above described epoxy resin, examples of matrix resin include thermo-setting resin such as unsaturated polyester resin, polyimide resin, BT resin, cyanate resin or thermoplastic resin such as PPO resin, polyether-imide resin, fluorine resin or resin made of a mixture thereof. Furthermore, it is also possible to use resin mixed with inorganic filler such as aluminum hydroxide.
   Furthermore, the amount of matrix resin stuck to the glass cloth is preferably determined so that the mass of the varnish solid content is 20% to 80% with respect to the total mass of the varnish solid content and glass cloth.
   Furthermore, it is also possible to paste metal foil to at least one side of the prepreg of the present invention to create a prepreg with metal foil and as a method of manufacturing such a prepreg with metal foil, it is possible to preferably use a method of heating metal foil and adhering it to the prepreg or a method of applying varnish to the glass cloth and metal foil simultaneously or the like.
   As the metal foil for the above described prepreg with metal foil, copper foil is normally used, but aluminum foil can also be used. Metal foil of 3 µm to 100 µm in thickness is preferably used though it depends on the applications.

(5) Manufacturing of printed wiring board
   A printed wiring board using the prepreg of the present invention can be manufactured following the method shown in the background art and related publicly known techniques.
   For example, it is possible to manufacture a double sided printed wiring board through a step of stacking a single or a plurality of prepregs of the present invention, pasting copper foil to both sides of the laminated sheet obtained and heating and pressing it to create a cured coppered laminated sheet, a step of creating a circuit pattern made up of copper foil on both sides of the coppered laminated sheet and a step of forming through holes and securing electrical connections between circuit patterns of both sides.
   Furthermore, it is also possible to suitably use a method whereby the prepreg of the present invention is subjected to boring using a laser to form IVHs, IVHs are filled with conductive paste, interconnecting prepregs for IVH connection are manufactured, the interconnecting prepregs are overlaid with a double sided printed wiring board or double sided conductive wiring sheet alternately, and molded with heat and pressure into a multilayer printed wiring board.
   As the molding condition in this case, the heating temperature is preferably 100°C to 230°C, the pressure is preferably 1 MPa to 5 MPa and the multilayer printed wiring board is preferably kept under this condition for 0.5 to 2.0 hours.
   As the method of forming IVHs in the prepreg of the present invention using a laser, methods using a carbon dioxide laser, YAG laser or excimer laser or the like can be used as appropriate. Furthermore, before and after heating, pressing and IVH work using a laser, it is also possible to paste an organic film or the like to the prepreg to protect or improve workability of the prepreg. As the organic film in this case, a polyethylene terephthalate film, polypropylene film, polyethylene film, fluorinated polyethylene film or the like can be used.
   Furthermore, when the IVH formed is filled with conductive paste, it is possible to use conductive paste of various publicly known materials such as copper, silver.

The present invention will be explained based on examples below.
Physical properties and gap length of the glass cloth, prepreg using the glass cloth, methods of creating a printed wiring board and testing methods in examples and comparative examples are as follows.
1. Method of measuring physical properties of glass cloth
   Measurement was conducted following JIS-R-3420.
2. Method of measuring gap length of glass cloth
   The glass cloth was observed using a microscope, pictures of the surface were taken, 20 gaps enclosed by warps and wefts were measured and a mean value of the length of the smaller side of each gap was considered as the gap length of the glass cloth.
3. Method of creating prepreg
   The glass cloth was impregnated with epoxy resin varnish prepared at the following blending ratio, extra resin varnish was scraped off with slits corresponding to approximately twice the thickness of each glass cloth, dried for three minutes at 170°C and a prepreg was thereby obtained.
   Blending ratio of epoxy resin varnish
   5046B80 (manufactured by Japan Epoxy Resins Co., Ltd., product name): 70% by mass, 180S75B70 (manufactured by Japan Epoxy Resins Co., Ltd., product name): 14% by mass, dicyandiamide: 1.6% by mass, 2-ethyl-4-methyl-imidazole: 0.2% by mass, dimethylformamide: 7.1% by mass, methyl cellosolve: 7.1% by mass
4. Method of creating substrate
   One or four prepregs of 340 mm long, 340 mm wide obtained using the above described method of creating a prepreg were stacked one atop another, 12 µm copper foil was placed on both sides, heated and pressed for an hour at 175°C and 3.9 MPa, cured and thereby a 1-ply substrate (one prepreg was stacked) for evaluations of dimensional stability and rigidity and a 4-ply substrate (four prepregs were stacked) for evaluation of coefficient of thermal expansion were obtained. Since the thickness of the glass cloth in Comparative Example 1, which will be described later, is approximately half that of Example 1 and 2 and Comparative Example 2 and the thickness of the glass cloth in Comparative Example 4 is approximately half that of Examples 3 to 7 and Comparative Example 3 and 5, a substrate for evaluations of dimensional stability and rigidity was created using a 2-ply substrate (two prepregs were stacked) and a substrate for evaluation of coefficient of thermal expansion was created using an 8-ply substrate (8 prepregs were stacked).

5. Method of measuring dimensional stability of substrate
   A total of 9 bench marks; 3 in the warp direction and 3 in the weft direction were marked at intervals of 125 mm on the 1-ply substrate (2-ply substrate in Comparative Examples 1 and 4) and 6 distances between neighboring two bench marks were measured (measured value a) in the warp direction and weft direction respectively. Next, copper foil was removed using etching processing, heated for 30 minutes at 170°C and then the distances between the bench marks were measured again (measured value b). The ratio (%) of the difference between measured value a and measured value b to measured value a was designated as a rate of dimensional change. A mean value of six measured values (referred to as "average of rate of dimensional change" in Table 1 and Table 2 which will be described later) and absolute values of values obtained by subtracting a minimum value from a maximum value of the six measured values of the rate of dimensional change (referred to as "variation of rate of dimensional change" in Table 1 and Table 2 which will be described later) were calculated in the longitudinal direction and lateral direction respectively.
6. Method of measuring rigidity (amount of deflection) of substrate
   The 1-ply substrate (2-ply substrate in only Comparative Example 1) obtained using the above described method of creating a substrate was rid of copper foil through etching processing, cut in rectangles of 125 mm long and 25 mm wide in the warp direction and weft direction respectively, fixed so that the length from the fulcrum to a free end was 100 mm, a load of 0.25 g was added to the free end, the amount of deflection of the cantilever was measured so as to be used as an index of rigidity.
7. Method of measuring coefficient of thermal expansion in Z direction (thickness direction) of substrate
   The 4-ply substrate (8-ply substrate in Comparative Examples 1 and 4) obtained using the above described method of creating a substrate was rid of copper foil through etching processing, cut into a substrate of 10 mm per side and the coefficient of thermal expansion between 50°C to 100°C was measured using TMA/SS6100 manufactured by Seiko Instruments Inc.

### <Example 1>

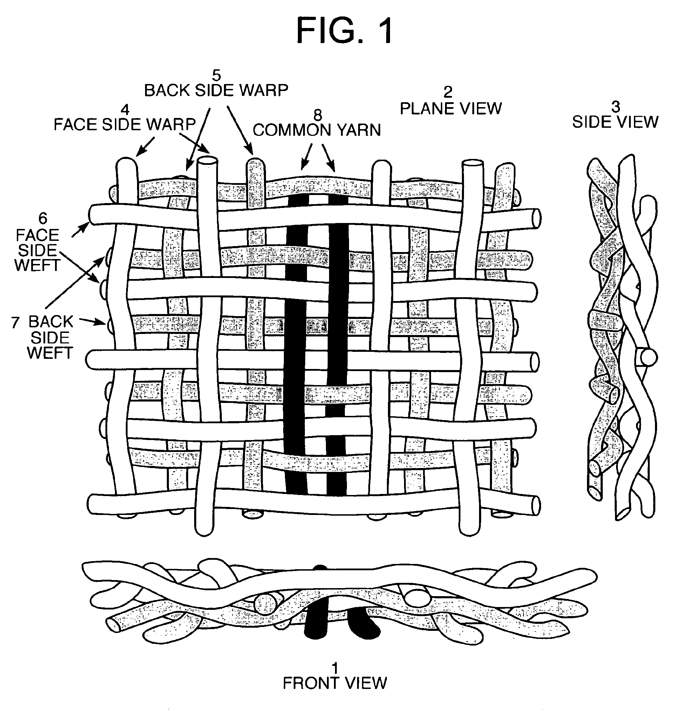

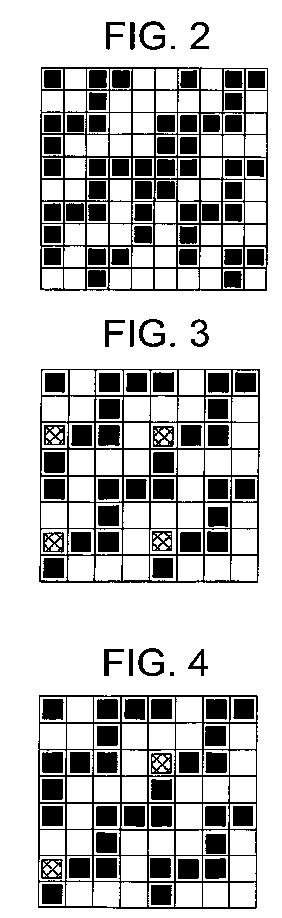

As a glass cloth, D450 1/0 1.0Z (yarn with 1.0 twist/inch) was used for warps and wefts, two single-piece cloths with one overlaid on the other were woven simultaneously using an air jet loom at a density of 90 warps/25 mm, 90 wefts/25 mm and using double yarns in both the longitudinal and lateral directions, and the upper and lower cloths were basically woven into a plain weave. To bind these upper and lower cloths, two of six warps were twill-woven, with four wefts bound with one warp, two wefts dislocated, four wefts bound with the other warp, and in this way greige fabric of glass cloth with one woven structure was obtained. Fig. 1 shows three side views showing the woven structure of the glass cloth and Fig. 2 shows a weave diagram. The number of binding points per unit structure (minimum repeating unit) is 2 (two) in this structure.
As is understandable with reference to Fig. 1, the woven structure of the glass cloth is constructed of a plain weave face side structure made up of face side warps and face side wefts, a plain weave back side structure made up of back side warps and back side wefts and common yarns for binding both structures of the face side structure and back side structure, and the face side structure is overlaid on the back side structure with the one dislocated from the other and bound together with two common yarns per unit structure.
The greige fabric obtained was subjected to fiber-opening process using high-pressure water spray and heat cleaning. D450 described above is a symbol which is an abbreviation of ECD450 of JIS R3413, "D" means a nominal diameter 5 (the same applies hereafter).
Next, as surface treatment, SZ6032 (manufactured by Dow Corning Toray Co., Ltd., product name) which is a silane coupling agent was used as a processing liquid, the glass cloth was immersed therein, and after squeezing out the liquid, the glass cloth was dried and subjected to fiber-opening process using a high-pressure water flow, a surface treated glass cloth was obtained and then used as a prepreg in Example 1 using the above described method of creating a prepreg. As is evident from the evaluation result shown in Table 1, the variation in the amount of dimensional change, amount of deflection and coefficient of thermal expansion in the Z direction of the substrate obtained using the prepreg were small.

### <Example 2>

As a glass cloth, D450 1/0 non-twist yarn (yarn with 0 twists/inch) was used for warps and wefts, two single-piece cloths with one overlaid on the other were woven simultaneously using an air jet loom at a density of 90 warps/25 mm, 90 wefts/25 mm and using double yarns in both the longitudinal and lateral directions, and the upper and lower cloths were basically woven into a plain weave. Except in that to bind these upper and lower cloths, two of six warps were twill-woven, with four wefts bound with one warp, two wefts dislocated, four wefts bound with the other warp, and in this way greige fabric of glass cloth with one woven structure was obtained, the same method as that in Example 1 was used to obtain a surface treated glass cloth and this was then used as a prepreg in Example 2 using the above described method of creating a prepreg. The woven structure of the glass cloth and weave diagram are the same as those of the glass cloth in Example 1. As is evident from the evaluation result shown in Table 1, the variation in the amount of dimensional change, amount of deflection and coefficient of thermal expansion in the Z direction of the substrate obtained using the prepreg were small.

### <Comparative Example 1>

Except in that as a glass cloth, D450 1/0 1.0Z was used for warps and wefts, greige fabric was obtained through plain weave using an air jet loom at a density of 45 warps/25 mm, 45 wefts/25 mm, the same method as that in Example 1 was used to obtain a surface treated glass cloth and this was then used as a prepreg in Comparative Example 1 using the above described method of creating a prepreg. As is evident from the evaluation result shown in Table 1, the variation in the amount of dimensional change, and coefficient of thermal expansion in the Z direction of the substrate obtained using two prepregs in Comparative Example 1 were large.

### <Comparative Example 2>

Except in that as a glass cloth, D225 1/0 1.0Z was used for warps and wefts, greige fabric was obtained through plain weave using an air jet loom at a density of 60 warps/25 mm, 57 wefts/25 mm, the same method as that in Example 1 was used to obtain a surface treated glass cloth and this was then used as a prepreg in Comparative Example 2 using the above described method of creating a prepreg. As is evident from the evaluation result shown in Table 1, the variation in the amount of dimensional change, the amount of deflection and coefficient of thermal expansion in the Z direction of the substrate obtained using the prepreg were large.

[Table 1]

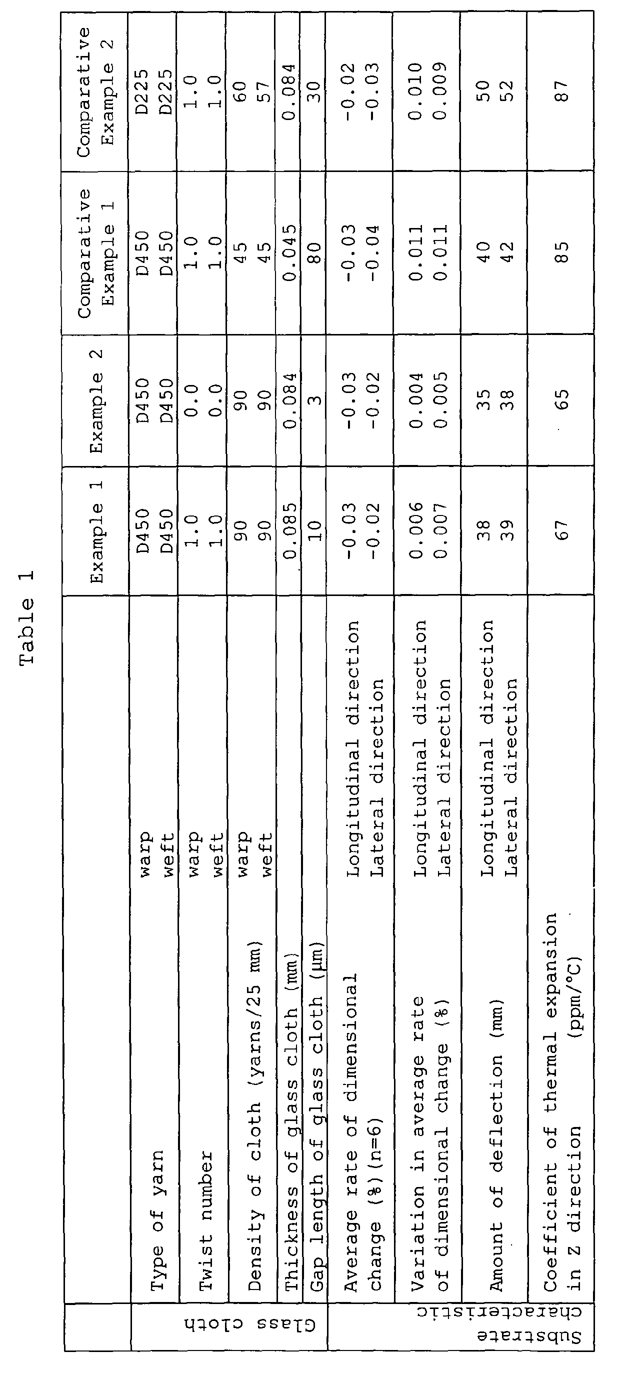

### <Example 3>

As a glass cloth, D900 1/0 1.0Z was used for warps and wefts, two single-piece cloths with one overlaid on the other were woven simultaneously using an air jet loom at a density of 112 warps/25 mm, 112 wefts/25 mm and using double yarns in both the longitudinal and lateral directions, and the upper and lower cloths were basically woven into a plain weave. Except in that to bind these upper and lower cloths, two of six warps were twill-woven, with four wefts bound with one warp, two wefts dislocated, four wefts bound with the other warp, and in this way greige fabric of glass cloth with one woven structure was obtained, the same method as that in Example 1 was used to obtain a surface treated glass cloth and this was then used as a prepreg in Example 3 using the above described method of creating a prepreg. The woven structure of the glass cloth and weave diagram are the same as those of the glass cloth in Example 1. As is evident from the evaluation result shown in Table 2, the variation in the amount of dimensional change, amount of deflection and coefficient of thermal expansion in the Z direction of the substrate obtained using the prepreg were small.

### <Example 4>

As a glass cloth, D900 1/0 1.0Z was used for warps and wefts, two single-piece cloths with one overlaid on the other were woven simultaneously using an air jet loom at a density of 112 warps/25 mm, 112 wefts/25 mm and using double yarns in both the longitudinal and lateral directions, and the upper and lower cloths were basically woven into a plain weave as the glass cloth shown in the weave diagram in Fig. 3. The same method as that in Example 1 was used to obtain a surface treated glass cloth and this was then used as a prepreg in Example 4 using the above described method of creating a prepreg. As is evident from the evaluation result shown in Table 2, the variation in the amount of dimensional change, amount of deflection and coefficient of thermal expansion in the Z direction of the substrate obtained using the prepreg were small.

### <Example 5>

As a glass cloth, D900 1/0 1.0Z was used for warps and wefts, two single-piece cloths with one overlaid on the other were woven simultaneously using an air jet loom at a density of 112 warps/25 mm, 112 wefts/25 mm and using double yarns in both the longitudinal and lateral directions, and the upper and lower cloths were basically woven into a plain weave as the glass cloth shown in the weave diagram in Fig. 4. The same method as that in Example 1 was used to obtain a surface treated glass cloth and this was then used as a prepreg in Example 5 using the above described method of creating a prepreg. As is evident from the evaluation result shown in Table 2, the variation in the amount of dimensional change, amount of deflection and coefficient of thermal expansion in the Z direction of the substrate obtained using the prepreg were small.

### <Example 6>

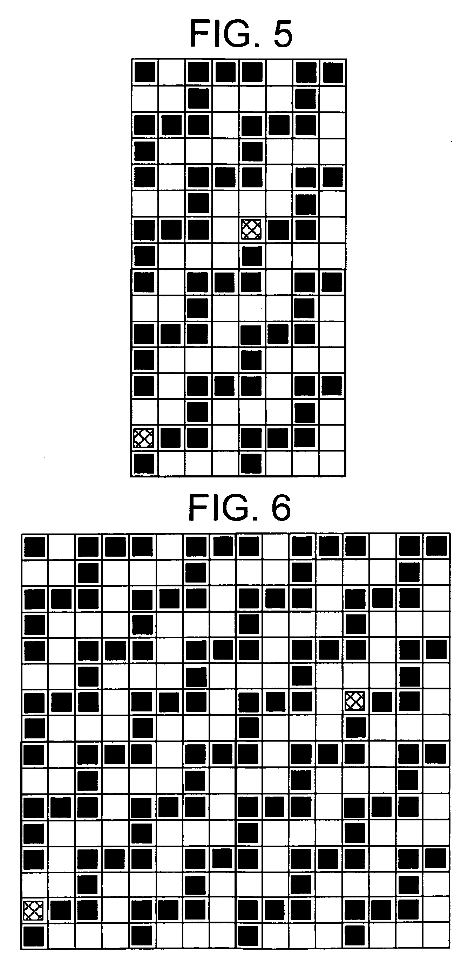

As a glass cloth, D900 1/0 1.0Z was used for warps and wefts, two single-piece cloths with one overlaid on the other were woven simultaneously using an air jet loom at a density of 112 warps/25 mm, 112 wefts/25 mm and using double yarns in both the longitudinal and lateral directions, and the upper and lower cloths were basically woven into a plain weave as the glass cloth shown in the weave diagram in Fig. 5. The same method as that in Example 1 was used to obtain a surface treated glass cloth and this was then used as a prepreg in Example 6 using the above described method of creating a prepreg. As is evident from the evaluation result shown in Table 2, the variation in the amount of dimensional change, amount of deflection and coefficient of thermal expansion in the Z direction of the substrate obtained using the prepreg were small.

### <Example 7>

As a glass cloth, D900 1/0 1.0Z was used for warps and wefts, two single-piece cloths with one overlaid on the other were woven simultaneously using an air jet loom at a density of 112 warps/25 mm, 112 wefts/25 mm and using double yarns in both the longitudinal and lateral directions, and the upper and lower cloths were basically woven into a plain weave as the glass cloth shown in the weave diagram in Fig. 6. The same method as that in Example 1 was used to obtain a surface treated glass cloth and this was then used as a prepreg in Example 7 using the above described method of creating a prepreg. As is evident from the evaluation result shown in Table 2, the variation in the amount of dimensional change, amount of deflection and coefficient of thermal expansion in the Z direction of the substrate obtained using the prepreg were small.

[Table 2]

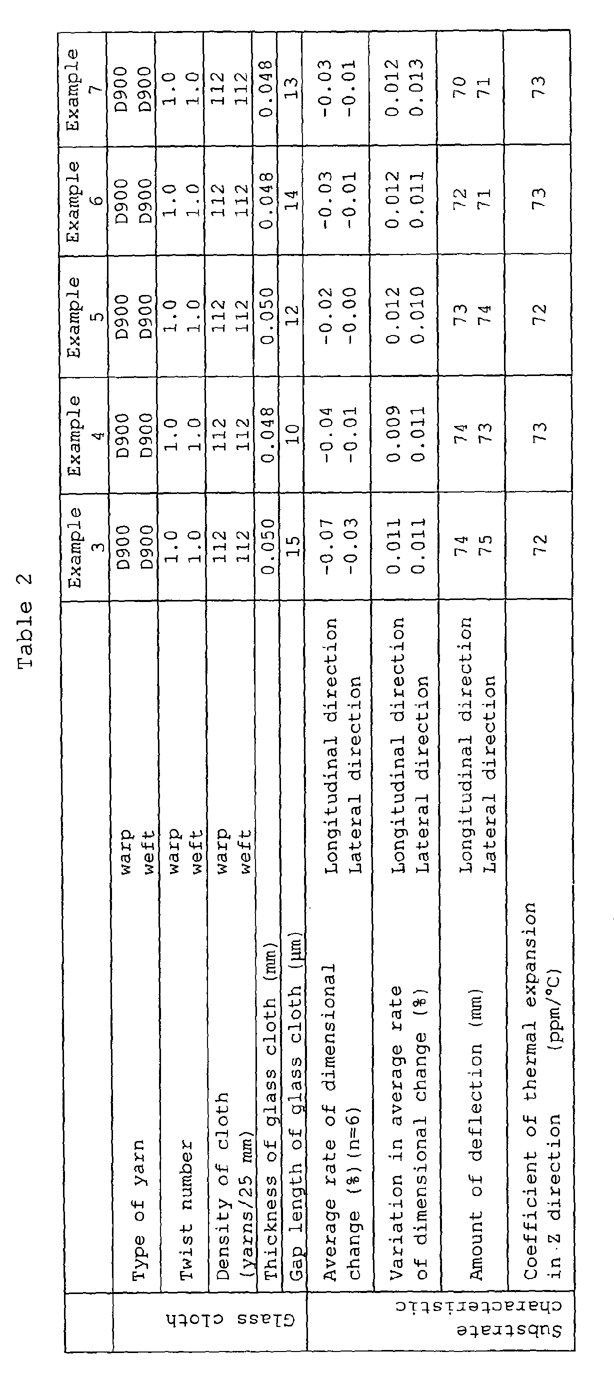

### <Comparative Example 3>

Except in that as a glass cloth, D900 1/0 1.0Z was used for warps and wefts, greige fabric was obtained through plain weave using an air jet loom at a density of 112 warps/25 mm, 112 wefts/25 mm, the same method as that in Example 1 was used to obtain a surface treated glass cloth and this was then used as a prepreg in Comparative Example 3 using the above described method of creating a prepreg. As is evident from the evaluation result shown in Table 3, the amount of deflection of the substrate obtained using one prepreg was large.
<Comparative Example 4>
Except in that as a glass cloth, D900 1/0 1.0Z was used for warps and wefts, greige fabric was obtained through plain weave using an air jet loom at a density of 56 warps/25 mm, 56 wefts/25 mm, the same method as that in Example 1 was used to obtain a surface treated glass cloth and this was then used as a prepreg in Comparative Example 4 using the above described method of creating a prepreg. As is evident from the evaluation result shown in Table 3, the variation in the amount of dimensional change and coefficient of thermal expansion in the Z direction of the substrate obtained using two prepregs in Comparative Example 4 were large.
<Comparative Example 5>
Except in that as a glass cloth, D450 1/0 1.0Z was used for warps and wefts, greige fabric was obtained through plain weave using an air jet loom at a density of 55 warps/25 mm, 54 wefts/25 mm, the same method as that in Example 1 was used to obtain a surface treated glass cloth and this was then used as a prepreg in Comparative Example 5 using the above described method of creating a prepreg. As is evident from the evaluation result shown in Table 3, the variation in the amount of dimensional change, amount of deflection and coefficient of thermal expansion in the Z direction of the substrate obtained using one prepreg in Comparative Example 5 were large.

[Table 3]

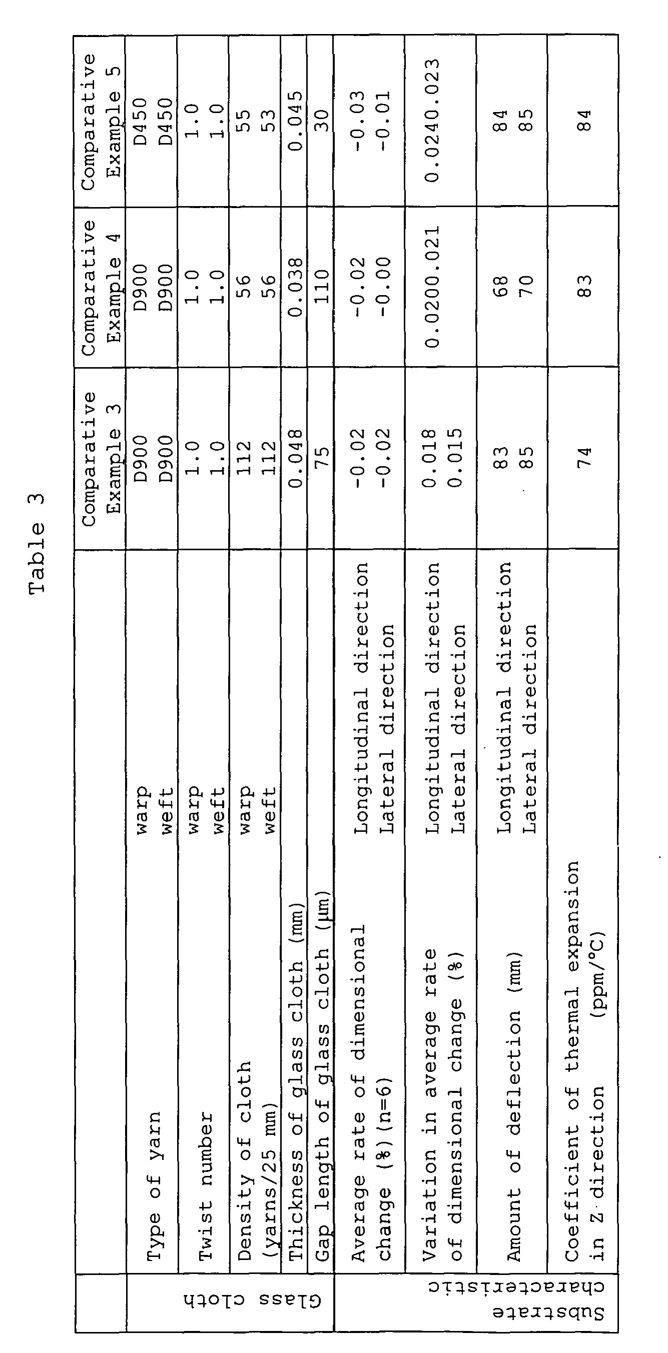

### Industrial Applicability

Since the present invention can improve productivity in steps of creating a prepreg and a multilayer printed wiring board and reduce variations in the amount of dimensional change and coefficient of thermal expansion in the thickness direction, can thereby be suitably used in the field of printed wiring boards.

## Claims

1. A double glass cloth for a printed wiring board, **characterized in that** it is composed of warps and wefts and has a double structure comprising a face side structure and a back side structure, wherein said face side structure and said back side structure are bound with a woven structure into one piece.

2. The double glass cloth according to claim 1, wherein the face side structure comprises face side warps which only weave said face side structure, face side wefts which only weave said face side structure and common yarns which weave both said face side structure and said back side structure, and the back side structure comprises back side warps which only weave said back side structure, back side wefts which only weave said back side structure and the common yarns which weave both said face side structure and said back side structure.

3. The double glass cloth according to claim 2, wherein the face side structure and back side structure comprise a plain weave.

4. The double glass cloth according to claim 2 or 3, wherein the face side structure and back side structure are bound together at a rate of at least one location per unit structure.

5. A prepreg for a printed wiring board comprising the double glass cloth according to any one of claims 1 to 4 and a semi-cured matrix resin.

6. A substrate for a printed wiring board formed by heating, pressing and curing the prepreg according to claim 5.

7. A method of manufacturing a printed wiring board comprising:
a step of stacking a single prepreg or a plurality of prepregs according to claim 5, pasting copper foil to both sides of the laminated sheet obtained and heating, pressing and curing the laminated sheet to thereby create a coppered laminated sheet;
a step of creating a circuit pattern made of copper foil on both sides of the coppered laminated sheet; and
a step of forming through holes and securing electrical connections between circuit patterns on both sides.

8. Use of the double glass cloth according to any one of claims 1 to 4 for a prepreg for a printed wiring board or a printed wiring board.
